# EUROPEAN PATENT APPLICATION

(11) **EP 4 521 557 A1**
(43) Date of publication of application: **12.03.2025**
(21) Application number: 22948332.6
(22) Date of filing: 29.06.2022
(51) Int. Cl.: H01Q 3/00, H04B 17/15, H01Q 25/00

(54) **ANTENNA ARCHITECTURE, AND METHOD FOR IMPROVING ANTENNA GAIN**

(71) Applicant: Huawei Technologies Co., Ltd., Shenzhen, Guangdong 518129 (CN)
(72) Inventor: FENG, Xin, Shenzhen, Guangdong 518129 (CN); SHEN, Mengkui, Shenzhen, Guangdong 518129 (CN); ZOU, Keli, Shenzhen, Guangdong 518129 (CN); MA, Chuanhui, Shenzhen, Guangdong 518129 (CN)
(74) Representative: Epping - Hermann - Fischer
(86) International application number: PCT/CN2022/102122
(87) International publication number: WO 2024/000212

(57) **Abstract**

This application provides an antenna architecture, including at least one drive structure. The drive structure includes a radio frequency amplifier and a reconfigurable antenna group. The reconfigurable antenna group includes a plurality of antenna units in a horizontal direction. The plurality of antenna units are arranged in a straight line. The horizontal direction is a direction parallel to the antenna architecture. The reconfigurable antenna group includes a plurality of optional beam directions. The radio frequency amplifier is configured to drive the plurality of antenna units in the reconfigurable antenna group. The reconfigurable antenna group is configured to transmit a signal in a target beam direction. The target beam direction is an optional beam direction closest to a target direction in the plurality of optional beam directions. **In** this application, in the antenna architecture, the radio frequency amplifier drives the plurality of antenna units, in the horizontal direction, of the reconfigurable antenna group, to increase a gain of the antenna architecture. In addition, the reconfigurable antenna group may select a beam direction closest to the target direction from the plurality of optional beam directions to transmit a signal, to further increase the gain of the antenna architecture.

## Description

### TECHNICAL FIELD

Embodiments of this application relate to the field of communication technologies, and in particular, to an antenna architecture and a method for increasing an antenna gain.

### BACKGROUND

In bands in mobile communication, a millimeter wave band with natural and cheap high-bandwidth resources has been a research and development hotspot in the communication field.

However, a millimeter wave has disadvantages of a high path loss and low diffraction. Due to the high path loss of the millimeter wave, a base station operating in the millimeter wave band needs to have a high antenna gain and transmit power to achieve target coverage performance, increasing site costs and power consumption. Due to the low diffraction of the millimeter wave, denser millimeter wave sites need to be deployed in hotspots such as urban areas, increasing networking costs.

In view of this, a solution for increasing an antenna gain of an antenna architecture needs to be developed urgently.

### SUMMARY

This application provides an antenna architecture and a method for increasing an antenna gain, to increase a gain of the antenna architecture.

According to a first aspect, this application provides an antenna architecture. The antenna architecture includes at least one drive structure. The drive structure includes a radio frequency amplifier and a reconfigurable antenna group. The reconfigurable antenna group includes a plurality of antenna units in a horizontal direction, and the plurality of antenna units are arranged in a straight line. The horizontal direction is a direction parallel to the antenna architecture. The radio frequency amplifier drives the plurality of antenna units in the reconfigurable antenna group. The reconfigurable antenna group in this application includes a plurality of optional beam directions. The reconfigurable antenna group transmits a signal at a moment in one of the optional beam directions. In this application, a target direction is a direction of transmitting a signal or receiving a signal. To increase a gain of the antenna architecture transmitting or receiving a signal in the target direction, a beam direction (that is, a target beam direction) used by the reconfigurable antenna group for transmitting or receiving a signal needs to be one optional beam direction closest to the target direction in the plurality of optional beam directions.

In this application, the antenna architecture uses the radio frequency amplifier to drive the plurality of antenna units, in the horizontal direction, of the reconfigurable antenna group to increase the gain of the antenna architecture. In addition, the reconfigurable antenna group may select a beam direction closest to the target direction from the plurality of optional beam directions to transmit or receive a signal, to further increase the gain of the antenna architecture.

Based on the first aspect, in a possible implementation, the antenna architecture includes a polygonal structure, for example, a regular hexagon, a regular octagon, a regular decagon, or a regular dodecagon. This is not specifically limited herein. The polygonal structure (the antenna architecture) includes a plurality of drive structures. Each edge of the polygonal structure includes at least one reconfigurable antenna group in the drive structure. Because the plurality of antenna units in the reconfigurable antenna group are arranged in a straight line, it may be considered that an edge of the polygonal structure includes the straight line in which the plurality of antenna units are arranged. Correspondingly, each reconfigurable antenna group in the polygonal structure is driven by one radio frequency amplifier. The reconfigurable antenna group on each edge of the polygonal structure (the antenna architecture) may transmit a signal to the outside or receive a signal. Therefore, the gain of the antenna architecture is increased, and a scanning range of the antenna architecture is further expanded.

Based on the first aspect, in a possible implementation, the antenna architecture includes a plurality of drive planes. Each drive plane includes a plurality of reconfigurable antenna groups in the drive structure, and there is a specific angle between different drive planes, so that the scanning range of the antenna architecture is expanded. Correspondingly, each reconfigurable antenna group in the drive plane is driven by one radio frequency amplifier. Functions such as phase shift and amplification of a radio frequency channel may be integrated into a multi-functional amplitude and phase control chip. One multi-functional amplitude and phase control chip may provide a plurality of radio frequency channels.

Based on the first aspect, in a possible implementation, the antenna architecture includes a plurality of drive planes. The plurality of drive planes are connected, so that the scanning range of the antenna architecture is expanded.

Based on the first aspect, in a possible implementation, the antenna architecture includes a cylindrical structure. The cylindrical structure includes a plurality of drive planes. The plurality of drive planes are connected to form the cylindrical structure in an enclosed manner. The antenna architecture is a complete cylindrical structure, so that the scanning range of the antenna architecture is further expanded, and 360° full coverage of the scanning range is implemented. Based on the first aspect, in a possible implementation, when the antenna architecture includes a plurality of drive planes, generally, not all the drive planes operate at a same moment. In this case, power consumption of the antenna architecture is excessively high. In addition, for a drive plane far away from the target direction, a gain of the drive plane transmitting or receiving a signal in the target direction is excessively low. Therefore, gains of all the drive planes operating at the same time are low. Therefore, the antenna architecture further includes a power-splitting gating network. The power-splitting gating network is for selecting a target drive plane from the plurality of drive planes in the antenna architecture. The target drive plane is at least one drive plane whose optional beam direction is closest to the target direction in the plurality of drive planes. In the antenna architecture, one or more drive planes closest to the target direction are selected by using the power-splitting gating network to operate, so that an antenna gain and a transmit power consumption benefit can be increased.

Based on the first aspect, in a possible implementation, the plurality of drive planes of the cylindrical structure in the antenna architecture greatly expand the scanning range of the antenna architecture. However, the bottom of the cylindrical structure is not covered by a scanning range of the drive plane. Therefore, if an electronic device is located at the bottom of the cylindrical structure, the electronic device cannot receive a signal from the antenna architecture, or cannot transmit a signal to the antenna architecture. In view of this, at least one antenna unit may be disposed at the bottom of the cylindrical structure in the antenna architecture. The antenna unit may be configured to transmit a signal to the bottom of the cylindrical structure or receive a signal from the bottom of the cylindrical structure. Therefore, when the electronic device is located at the bottom of the cylindrical structure, the electronic device can still receive a signal from the antenna architecture or transmit a signal to the antenna architecture, so that the scanning range of the antenna architecture is further expanded.

According to a second aspect, this application provides a method for increasing an antenna gain. The method is applied to an antenna architecture. The antenna architecture includes at least one drive structure. The drive structure includes a radio frequency amplifier and a reconfigurable antenna group. The reconfigurable antenna group includes a plurality of antenna units in a horizontal direction. The plurality of antenna units are arranged in a straight line. The horizontal direction is a direction parallel to the antenna architecture. The reconfigurable antenna group includes a plurality of optional beam directions. The radio frequency amplifier is configured to drive the plurality of antenna units in the reconfigurable antenna group. The method includes:
determining a target beam direction in the plurality of optional beam directions, where the target beam direction is an optional beam direction closest to a target direction in the plurality of optional beam directions; and
transmitting or receiving a signal in the target beam direction.

Based on the second aspect, in a possible implementation, the antenna architecture includes a polygonal structure, the polygonal structure includes a plurality of drive structures, and each edge of the polygonal structure includes at least one reconfigurable antenna group in the drive structure. The method further includes:
determining a target drive edge, where the target drive edge is at least one edge closest to the target direction in the polygonal structure; and
the determining a target beam direction in the plurality of optional beam directions includes:
   determining the target beam direction in the plurality of optional beam directions of the target drive edge.

Based on the second aspect, in a possible implementation, the antenna architecture includes a cylindrical structure, the cylindrical structure includes a plurality of drive planes, and each drive plane includes a plurality of reconfigurable antenna groups in the drive structure. The method further includes:
determining a target drive plane, where the target drive plane is at least one drive plane whose optional beam direction is closest to the target direction in the plurality of drive planes; and
the determining a target beam direction in the plurality of optional beam directions includes:
   determining the target beam direction in the plurality of optional beam directions of the target drive plane.

### BRIEF DESCRIPTION OF DRAWINGS

To describe the technical solutions in embodiments of this application or in the current technologies more clearly, the following briefly describes the accompanying drawings for describing embodiments or the current technologies. It is clear that the accompanying drawings in the following descriptions show merely embodiments of this application. A person of ordinary skill in the art may still obtain another accompanying drawing from the provided accompanying drawings without creative efforts.
FIG. 1 is a diagram of a scenario in which a macro site cooperates with a pole site in networking in an enhanced mobile broadband;
FIG. 2 is a diagram of structures of a cylindrical conformal semi-omnidirectional array antenna and a polyprism conformal omnidirectional array antenna;
FIG. 3 is a diagram of a structure of a switched conformal array;
FIG. 4 is a diagram of a structure of a passive phase-shift conformal array;
FIG. 5 is a diagram of a structure of an active phase-shift one-drive-one conformal array;
FIG. 6 is a diagram of a structure of an active phase-shift one-drive-multiple conformal array;
FIG. 7 is a diagram of changes of a gain of an antenna architecture with a quantity of excitation columns and a radius of a cylindrical array;
FIG. 8 is a diagram of a gain combination of a cylindrical array;
FIG. 9 is a diagram of a typical application scenario of a pole site;
FIG. 10 is a diagram of an operating principle of a pole site;
FIG. 11 is a diagram of a solution of a signal gain of an antenna architecture in a target direction according to this application;
FIG. 12 is a diagram in which a reconfigurable antenna group includes a plurality of optional beam directions according to this application;
FIG. 13 is a diagram of a structure of a drive plane according to this application;
FIG. 14 is a diagram of a structure of a plurality of connected drive planes according to this application;
FIG. 15 is a diagram in which a plurality of drive planes in an antenna architecture cooperate with a power-splitting gating network in operation according to this application;
FIG. 16 is a diagram of an operating state of a plurality of drive planes in an antenna architecture;
FIG. 17 is a diagram of a scenario in which the bottom of a cylindrical structure includes an antenna unit according to this application; and
FIG. 18 is a diagram of a structure of the bottom of an antenna architecture according to this application.

### DESCRIPTION OF EMBODIMENTS

This application provides an antenna architecture and a method for increasing an antenna gain, to increase a gain of the antenna architecture.

The following describes embodiments of the present invention with reference to the accompanying drawings in embodiments of the present invention. Terms used in embodiments of the present invention are merely intended to explain specific embodiments of the present invention, and are not intended to limit the present invention. A person of ordinary skill in the art may know that with the development of technologies and emergence of new scenarios, technical solutions provided in embodiments of this application are also applicable to a similar technical problem.

In this application, "at least one" means one or more, and "plurality of" means two or more. "And/or" describes an association relationship between associated objects and indicates that three relationships may exist. For example, A and/or B may indicate the following three cases: Only A exists, both A and B exist, and only B exists, where A and B may be singular or plural. The character "/" generally indicates an "or" relationship between the associated objects. "At least one of the following items (pieces)" or a similar expression thereof refers to any combination of these items, including any combination of singular items (pieces) or plural items (pieces). For example, at least one of a, b, or c may indicate: a, b, c, a-b, a-c, b-c, or a-b-c, where a, b, and c may be singular or plural.

In the specification, the claims, and the accompanying drawings of the present invention, the terms "first", "second", "third", "fourth", and the like (if any) are intended to distinguish between similar objects but do not necessarily indicate a specific order or sequence. It should be understood that the data termed in such a way are interchangeable in appropriate circumstances, so that embodiments of the present invention described herein can be implemented in orders except the orders illustrated or described herein. In addition, the terms "include" and "have" and any other variants thereof are intended to cover a non-exclusive inclusion. For example, a process, a method, a system, a product, or a device that includes a list of steps or units is not necessarily limited to those expressly listed steps or units, but may include other steps or units not expressly listed or inherent to such a process, method, product, or device.

First, technical terms in this application are described.

Enhanced mobile broadband (enhanced mobile broadband, eMBB): The eMBB further improves service experience based on an existing mobile broadband service. An eMBB scenario mainly focuses on ultimate communication experience between people, and corresponds to heavy-traffic mobile broadband services such as augmented reality (augmented reality, AR) or virtual reality (virtual reality, VR), and ultra-high-definition videos.

Phased array: An antenna array performs amplitude and phase weighting on each antenna unit to flexibly control beam sweeping and the like of an antenna. A phase is usually weighted through a phase shifter.

Active phase shift: A power amplifier (power amplifier, PA) is located closest to an antenna unit, and a phase shifter is located before the power amplifier. That is, phase shift is performed before power amplification. Usually, each antenna unit (or each subarray including several antenna units) corresponds to one amplifier.

Passive phase shift: After signals pass through the PA, processing such as power splitting and phase shift is performed. That is, power amplification is performed before phase shift. Usually, there is only one amplifier on an entire antenna array. Beam sweeping is performed through phase shift after the PA.

Next, possible application scenarios in this application are described.

In bands in mobile communication, a millimeter wave band with natural and cheap high-bandwidth resources has been a research and development hotspot in the communication field.

However, a millimeter wave has disadvantages of a high path loss and low diffraction. Due to the high path loss of the millimeter wave, a base station operating in the millimeter wave band needs to have a high antenna gain and transmit power to achieve target coverage performance, increasing site costs and power consumption. Due to the low diffraction of the millimeter wave, denser millimeter wave sites need to be deployed in hotspots such as urban areas, increasing networking costs.

To compensate for a coverage vacancy caused by the disadvantage of the millimeter wave, in a millimeter wave band of a 5th generation (5th generation, 5G) mobile communication system, a solution in which a macro site cooperates with a pole site in networking is usually used in an enhanced mobile broadband (enhanced mobile broadband, eMBB) scenario in a dense urban area.

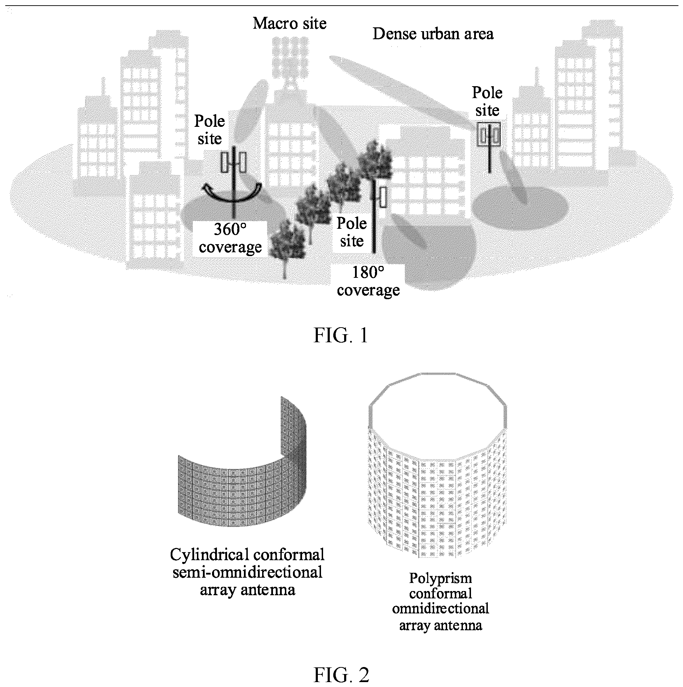

FIG. 1 is a diagram of a scenario in which a macro site cooperates with a pole site in networking in an enhanced mobile broadband. In the scenario shown in FIG. 1, a planar phased array usually used by an existing antenna in a millimeter wave pole site has two main disadvantages: One disadvantage is that there is a contradiction between a high gain and a high transmit power and costs and power consumption. In other words, to achieve a target coverage capability, either costs and power consumption of a single site are increased, or a deployment density is increased. The other disadvantage is that a scanning range of a single module is only ±60°, so that three modules are required at the single site to achieve 360° omnidirectional coverage. This also increases costs and power consumption of the single site. These disadvantages lead to high costs of millimeter wave eMBB network construction and operation, resulting in poor user experience.

It can be learned from the foregoing descriptions that the foregoing networking solution has a strong requirement for a single module to implement 180° or 360° beam sweeping. The analysis shows that an improvement in a beam sweeping capability of the single module can not only reduce a quantity of modules required by a site, but also reduce a quantity of sites required for networking, to effectively reduce network construction costs. In addition, with the improvement in the beam sweeping capability of the single module, power consumption of the single module is required to be as low as possible, to reduce operation costs.

To implement semi-omnidirectional (180°) or omnidirectional (360°) scanning, a common method is to arrange antennas along a side surface of a cylinder or a polyprism to form a conformal array. FIG. 2 is a diagram of structures of a cylindrical conformal semi-omnidirectional array antenna and a polyprism conformal omnidirectional array antenna. As shown in FIG. 2, layouts of the two types of antenna arrays may be divided into a horizontal annular array multiplied by a linear array in a vertical direction according to a principle of pattern multiplication. In other words, a plurality of annular arrays form the linear array in the vertical direction. Horizontal annular arrays are classified into a plurality of types based on drive structures, including a switched conformal array, a passive phase-shift conformal array, and an active phase-shift one-drive-one conformal array or an active phase-shift one-drive-multiple conformal array. It should be understood that "one-drive-one" and "one-drive-multiple" in this application represent a quantity of antenna units driven by one radio frequency amplifier. Specifically, "one-drive-one" means that one radio frequency amplifier drives one antenna unit, and "one-drive-multiple" means that one radio frequency amplifier drives a plurality of antenna units.

A plurality of existing types of conformal arrays are analyzed below by using an annular array that is obtained by truncating a polyprism conformal omnidirectional array antenna (the same applies to a cylindrical conformal omnidirectional array antenna) in FIG. 2 in a horizontal plane (which is equivalent to a top view).

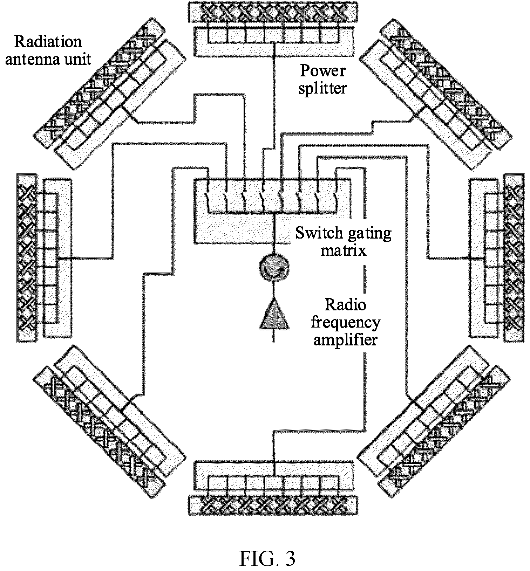

FIG. 3 is a diagram of a structure of a switched conformal array. It should be noted that FIG. 3 shows an annular array of the switched conformal array on a horizontal cross section. In practice, a plurality of annular arrays shown in FIG. 3 need to be superposed in a vertical direction to form a multi-plane switched conformal array. As shown in FIG. 3, after a radio frequency signal passes through a power amplifier, a switch gating matrix and a power splitter can allocate the signal to one or more groups of corresponding radiating antenna units based on a target scanning direction. For example, there are eight groups of antennas in FIG. 3, and a simplest signal allocation method is that signals are separately allocated to the eight groups of antennas, so that beam directions in eight directions can be formed. A slightly complex allocation method is that signals can be allocated to two adjacent groups of antennas, so that beam directions in eight directions can be formed additionally.

This drive structure is simple with a small quantity of active channels and simple antenna units, and only involves some circuit networks such as the switch gating matrix and a power-splitting matrix. However, performance that can be achieved by the drive structure is also limited. For a polygonal annular array, a quantity of beams that can be generated is basically equal to a quantity of polygon edges. Even if an antenna gain on each edge of a polygon can be increasing by increasing a length of the edge of the polygon, a reduction in a beam width causes a coverage vacancy in a horizontal direction. In addition, a radius increases, and a corresponding module size increases. This is unfavorable for module deployment. For a circular array, even if a quantity of drive antenna units can be flexibly configured by using a switch power-splitting gating network, because each antenna unit has an equi-amplitude in-phase configuration, a quantity of antenna units that can be used by the circular array and a gain of the antenna unit are also limited. In other words, after the quantity of antenna units exceeds a specific number, the gain is reduced. For the circular array, a typical operating angle for a maximum gain is approximately 30° in the case of equi-amplitude in-phase feeding.

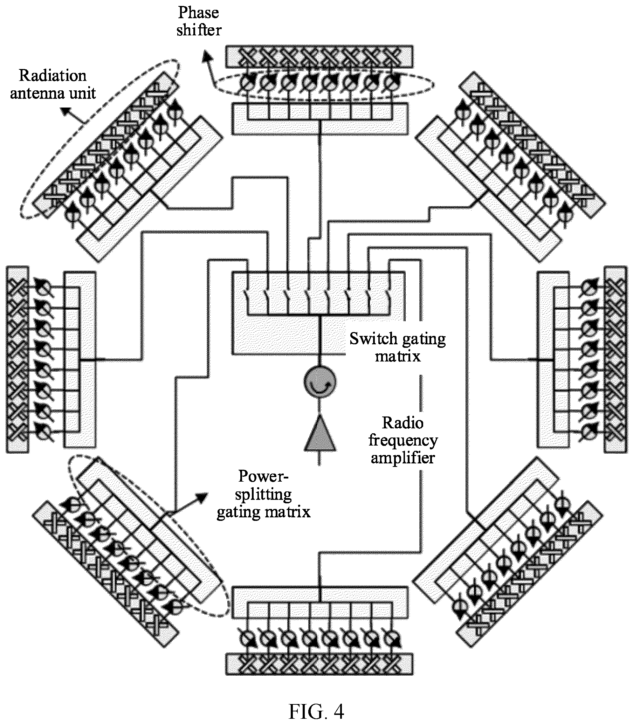

FIG. 4 is a diagram of a structure of a passive phase-shift conformal array. As shown in FIG. 4, from the perspective of a signal transmission flow direction, the passive phase-shift conformal array mainly includes a radio frequency amplifier, a circulator, a switch gating matrix, signal wiring, a conversion adapter, a power-splitting gating matrix, a phase shifter, and a radiation antenna. It can be learned that an architecture of this passive phase-shift conformal array is characterized by a long concatenation link and a large quantity of components. Compared with a switched conformal array, the passive phase-shift conformal array additionally includes one stage of phase shifter before each radiation antenna unit, so that more beam directions can be generated than those generated in the switched conformal array, and flexibility of an annular array is improved. However, a component after the radio frequency amplifier on the link introduces an insertion loss. Therefore, the architecture of this passive phase-shift conformal array has a larger insertion loss, and power consumption of the passive phase-shift conformal array is increased.

Based on the switched conformal array shown in FIG. 3, the passive phase-shift conformal array shown in FIG. 4 additionally includes one stage of phase shifter before each antenna unit, so that each antenna unit of the annular array is not limited to in-phase feeding, and corresponding phase weighting can be performed. In this way, the operating angle for the maximum gain can be increased from 30° to approximately 120°, and aperture utilization is improved. That is, in the case of an annular array with a same radius, a second architecture can provide a higher gain than a first architecture. However, links of the first architecture and the second architecture are both long, and an extra insertion loss is introduced at each stage. The phase shifter added to the passive phase-shift conformal array further increases an insertion loss of the link. A typical insertion loss of a 28 GHz 2-bit phase shifter is 2 dB. This is very unfavorable for indicators such as efficiency and power consumption of a base station.

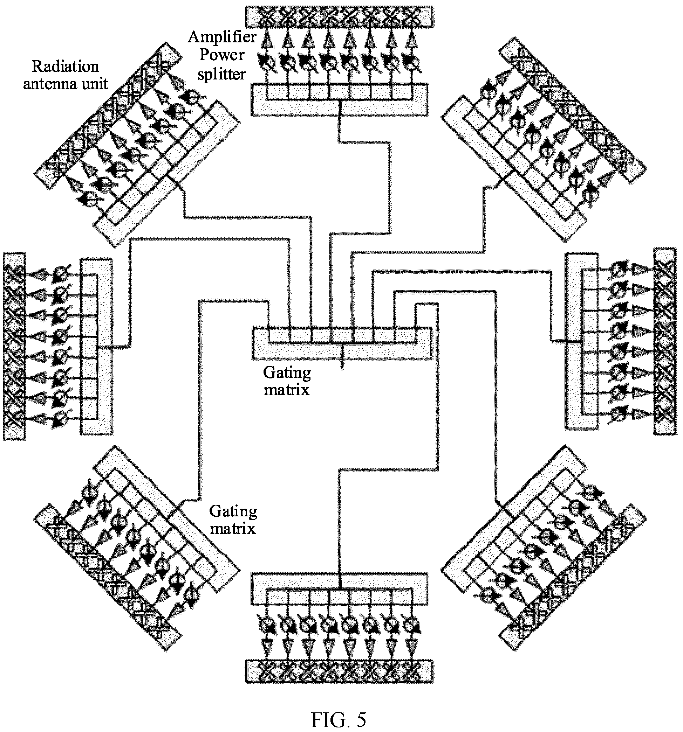

FIG. 5 is a diagram of a structure of an active phase-shift one-drive-one conformal array. As shown in FIG. 5, compared with the passive phase-shift conformal array shown in FIG. 4, a radio frequency amplifier in an architecture of the active phase-shift one-drive-one conformal array is moved forward to an antenna unit. Each antenna unit corresponds to one radio frequency amplifier and one phase shifter. In an actual implementation, because there are a large quantity of antenna units, a large quantity of radio frequency channels are also required. These channels are usually integrated into a radio frequency chip with multi-channel amplification and phase shift functions. Compared with passive phase shift, the architecture of this active phase-shift one-drive-one conformal array further improves beam flexibility, and minimizes a length of a link between a power amplifier and an antenna, so that an insertion loss is minimized and power consumption is reduced.

In the architecture of the active phase-shift one-drive-one conformal array, the amplifier is moved forward to the antenna unit, so that a distance between the amplifier and the antenna unit is minimized, an output power is not consumed by a loss in the link, and efficiency of the antenna architecture is improved. These amplification and phase-shift functions are usually integrated into a multi-functional and multi-channel radio frequency chip. A disadvantage of the active phase-shift architecture is that costs and power consumption increase with an increase in an antenna scale, especially for a large-scale phased array.

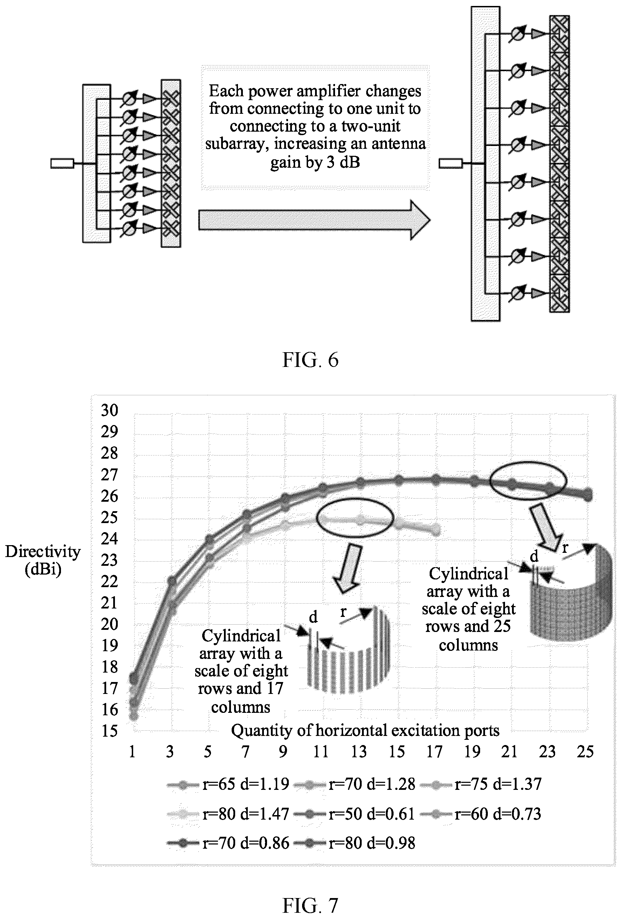

FIG. 6 is a diagram of a structure of an active phase-shift one-drive-multiple conformal array. In the active phase-shift one-drive-multiple conformal array shown in FIG. 6, based on the active phase-shift one-drive-one annular array in FIG. 5, a group of antennas is evolved from a one-drive-one structure to a one-drive-two structure. Each radio frequency amplifier changes from driving one unit to driving two units. A quantity of radio frequency channels remains unchanged, and chip costs and power consumption basically remain unchanged. Advantages of this active phase-shift one-drive-multiple conformal array are that an antenna scale is doubled and a theoretical antenna gain is increased by 3 dB, but a scanning range is reduced.

In an architecture of the active phase-shift one-drive-multiple conformal array, the one-drive-one structure is evolved to a one-drive-multiple structure (where the one-drive-multiple structure may be equivalent to expanding a drive spacing when a gain of an antenna unit is high enough, for example, the one-drive-two structure is equivalent to the one-drive-one structure, but the spacing is doubled), and it is expected that an antenna gain is increased while chip costs and power consumption remain basically unchanged. For a planar array, a gain is increased at the expense of a specific scanning range. For an annular array and a cylindrical array formed by superposing annular arrays in a vertical direction, the problem is not about a horizontal scanning range, but driving more units or expanding a spacing in the annular array does not increase a gain. This case is described below with reference to FIG. 7.

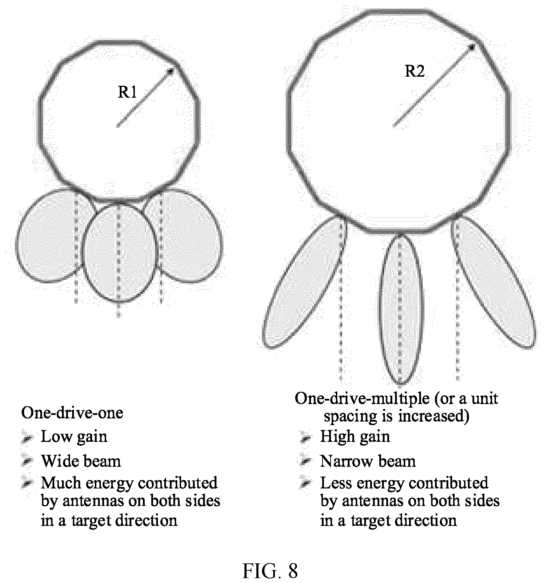

FIG. 7 is a diagram of changes of a gain of an antenna architecture with a quantity of excitation columns and a radius of a cylindrical array. FIG. 7 shows cylindrical arrays of two scales (scale 1 and scale 2). In scale 1, 17 columns are arranged in a horizontal direction and eight rows are arranged in a vertical direction. In scale 2, 25 columns are arranged in a horizontal direction and eight rows are arranged in a vertical direction. FIG. 7 shows maximum gains that can be achieved at the two scales in the case of different radius parameters (different scales) and excitation conditions. As shown in FIG. 7, the gain of the antenna architecture increases as a quantity of excitation ports increases, and the gain tends to be saturated or even decrease after increasing to a specific extent. A saturation point of a gain at scale 1 is located in column 11, and a saturation point of a gain at scale 2 is located in column 19. The two saturation points approximately correspond to an angle range of 120°, as proved by the foregoing conclusion. In addition, two clusters of curves of the gains at the two scales that change with the radius overlap, indicating that when the quantity of excitation ports remains unchanged, the gain does not increase with an increase in the radius of the antenna architecture. In addition, the gain at scale 2 is higher than that at scale 1. However, to achieve a same scanning angle, more excitation columns are required at scale 2, so that higher chip costs and power consumption are required. A case in which a gain of a cylindrical array does not increase with an increase in a radius or an area of a corresponding projection aperture of the cylindrical array is described below with reference to FIG. 8.

FIG. 8 is a diagram of a gain combination of a cylindrical array. FIG. 8 shows two antenna architectures. In a horizontal one-drive-one antenna architecture (shown on the left side of FIG. 8), a gain of each antenna unit is low, but a beam is wide, and gains of antennas on both sides in a target direction are large. In a one-drive-multiple antenna architecture (shown on the right side of FIG. 8), a gain of each antenna unit is high, but a beam is narrow, and gains of antennas on both sides in the target direction are low. Combined gains of the two antenna architectures are basically the same. This is why a gain does not increase with a radius.

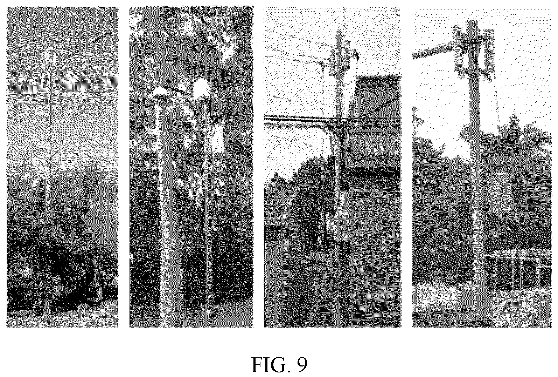

In view of this, this application provides an antenna architecture and a method for increasing an antenna gain, to increase a gain of the antenna architecture transmitting a signal in a target direction. The antenna architecture and the method for increasing an antenna gain in this application may be applied to an evolved base station in a long term evolution (long term evolution, LTE) system, a base station in a 5G mobile communication system, a base station in a future mobile communication system, or the like. Specifically, the base station may be a macro base station, a micro base station, or the like. A most typical scenario is that the antenna architecture and the method are applied to a pole site. FIG. 9 is a diagram of a typical application scenario of a pole site. As shown in FIG. 9, the pole site is characterized by a small size, low power consumption, and easy access, and may be deployed on a lamp pole, a surveillance pole, a power pole, or a traffic pole, or at another position. The pole site can be used to supplement areas that are difficult to be covered by a macro base station.

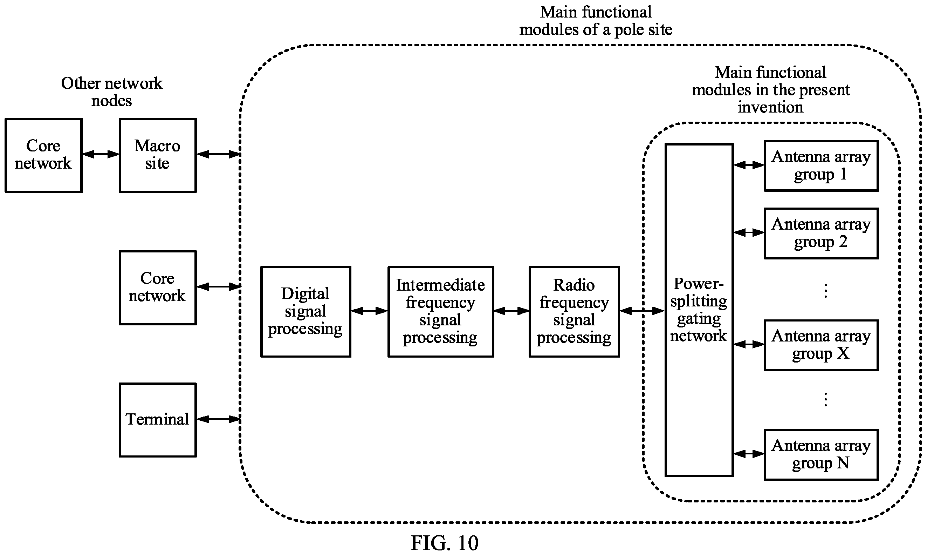

FIG. 10 is a diagram of an operating principle of a pole site. A position of the pole site in a network is shown in FIG. 10. In some scenarios, the pole site can be directly connected to a core network for communication. In some scenarios, the pole site can be used as a relay node to communicate with a macro site, and can also communicate with a terminal user. The pole site, which includes a digital functional module, an intermediate frequency functional module, a radio frequency functional module, and another functional module, is mainly responsible for performing various types of processing on a signal. A function of a power-splitting gating network is to connect a signal processing module and an antenna array. A function of an antenna array module is to transmit an electromagnetic wave signal to space or receive an electromagnetic wave signal from space. This application mainly relates to the power-splitting gating network and the antenna array module.

The following describes the antenna architecture in this application.

The antenna architecture in this application includes at least one drive structure. The drive structure includes a radio frequency amplifier and a reconfigurable antenna group. The reconfigurable antenna group includes a plurality of antenna units. The plurality of antenna units is arranged in a straight line, and the plurality of antenna units in the reconfigurable antenna group are driven by the radio frequency amplifier. For a structure herein, refer to the one-drive-multiple (that is, one radio frequency amplifier drives a plurality of antenna units) antenna architecture shown in FIG. 6. As shown in FIG. 6, in the antenna architecture on the right side, each radio frequency amplifier is connected to two antenna units. The two antenna units are arranged in a straight line, and the radio frequency amplifier is responsible for driving the two antenna units. Therefore, a combination of "one radio frequency amplifier and two antenna units" shown in FIG. 6 is equivalent to a drive structure in this application.

The reconfigurable antenna group in this application includes a plurality of optional beam directions in a horizontal direction. The horizontal direction is a direction parallel to the antenna architecture. The reconfigurable antenna group transmits or receives a signal at a moment in one of the optional beam directions. In this application, a target direction is a direction of transmitting a signal or receiving a signal. To increase a gain of the antenna architecture transmitting or receiving a signal in the target direction, a beam direction (that is, a target beam direction) used by the reconfigurable antenna group for transmitting or receiving a signal needs to be one optional beam direction closest to the target direction in the plurality of optional beam directions.

It should be noted that the antenna architecture in this application may be used to receive a signal, or may be used to transmit a signal. This is not limited in this application. For ease of description, the following describes the antenna architecture in this application by using the antenna architecture used for transmitting a signal as an example. A description of the antenna architecture receiving a signal and a solution of the antenna architecture transmitting a signal are based on a same concept. Details are not described.

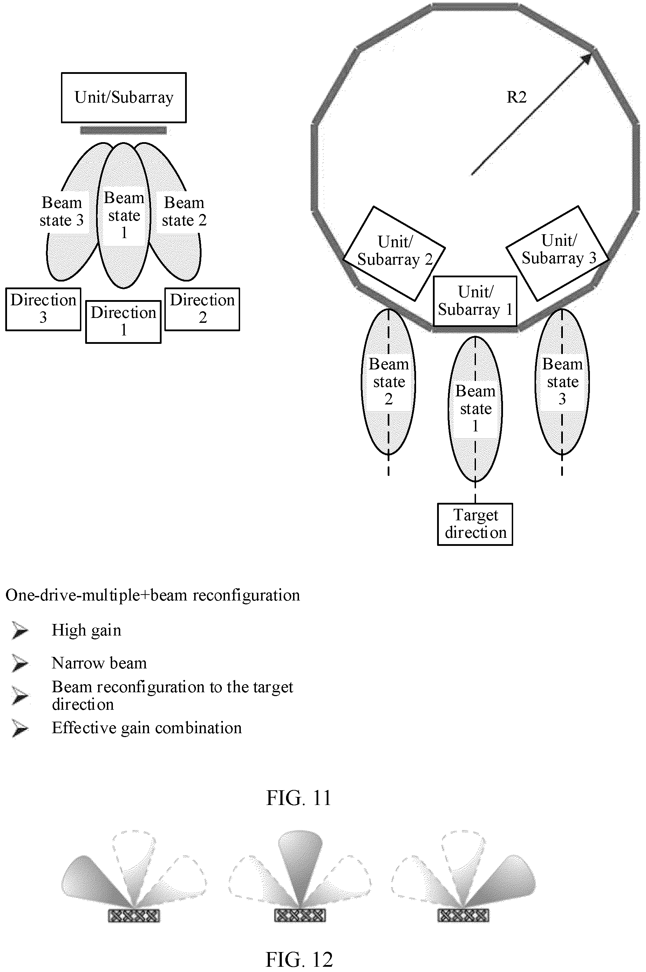

FIG. 11 is a diagram of a solution of a signal gain of the antenna architecture in the target direction according to this application. In this example, the antenna architecture is a cylindrical array similar to the polyprism shown in FIG. 2. It should be noted that FIG. 11 shows an annular array of the cylindrical array in a horizontal cross section. In actual application, a plurality of annular arrays shown in FIG. 11 need to be superposed in a vertical direction to form the cylindrical array. As shown in FIG. 11, each edge of the cylindrical array includes a reconfigurable antenna group in this application. Therefore, a plurality of antenna units in each reconfigurable antenna group are driven by one radio frequency amplifier (which is a one-drive-multiple structure). The reconfigurable antenna group includes three beam states (beam state 1, beam state 2, and beam state 3), which respectively correspond to three different beam directions (direction 1, direction 2, and direction 3). The reconfigurable antenna group may select any beam state to operate. The reconfigurable antenna group in the cylindrical array selects a beam direction closest to the target direction to transmit a signal. It is assumed that in FIG. 11, three reconfigurable antenna groups (reconfigurable antenna group 1, reconfigurable antenna group 2, and reconfigurable antenna group 3) are operating, and a dashed line direction is the target direction. In this case, leftmost reconfigurable antenna group 2 operates in beam state 2, middle reconfigurable antenna group 1 operates in beam state 1, and rightmost reconfigurable antenna group 3 operates in beam state 3. Therefore, a signal gain of the antenna architecture in the target direction is increased.

FIG. 12 is a diagram in which a reconfigurable antenna group includes a plurality of optional beam directions according to this application. As shown in FIG. 12, the reconfigurable antenna group includes three optional beam directions (left, middle, and right). The reconfigurable antenna group selects only one optional beam direction (shaded parts in FIG. 11) at a moment: At a first moment, if the reconfigurable antenna group selects the left optional beam direction, a direction of transmitting a signal by the reconfigurable antenna group is the left optional beam direction; at a second moment, if the reconfigurable antenna group selects the middle optional beam direction, a direction of transmitting a signal by the reconfigurable antenna group is the middle optional beam direction; and at a third moment, if the reconfigurable antenna group selects the left optional beam direction, a direction of transmitting a signal by the reconfigurable antenna group is the right optional beam direction.

Further, the plurality of optional beam directions included in the reconfigurable antenna group may be implemented by a beam-reconfigurable technology of an antenna unit or a beam-reconfigurable technology of an antenna unit subarray. Specifically, in the beam-reconfigurable technology of the antenna unit, each antenna unit can configure one of a plurality of optional beam directions when the antenna unit is designed or manufactured. Antenna units connected to a same radio frequency amplifier belong to a same antenna unit subarray. In the beam-reconfigurable technology of the antenna unit subarray, a beam direction of each antenna unit subarray may be reconfigured by changing an excitation phase of an antenna unit in the antenna unit subarray, to point to a plurality of directions. It should be noted that, in actual application, in addition to the beam-reconfigurable technology of the antenna unit and the beam-reconfigurable technology of the antenna unit subarray that are described above, there is another technical means to implement a capability of the reconfigurable antenna group in including a plurality of optional beam directions. This is not specifically limited herein.

In this application, the antenna architecture uses the radio frequency amplifier to drive the plurality of antenna units, in the horizontal direction, of the reconfigurable antenna group to increase the gain of the antenna architecture. In addition, the reconfigurable antenna group may select a beam direction closest to the target direction from the plurality of optional beam directions to transmit or receive a signal, to further increase the gain of the antenna architecture.

In actual application, the gain of the antenna architecture may be further increased by increasing a spacing between antenna units.

In a possible implementation, the antenna architecture includes a polygonal structure, for example, a regular hexagon, a regular octagon, a regular decagon, or a regular dodecagon. This is not specifically limited herein. The polygonal structure (the antenna architecture) includes a plurality of drive structures. Each edge of the polygonal structure includes at least one reconfigurable antenna group in the drive structure. Because the plurality of antenna units in the reconfigurable antenna group are arranged in a straight line, it may be considered that an edge of the polygonal structure includes the straight line in which the plurality of antenna units are arranged. Correspondingly, each reconfigurable antenna group in the polygonal structure is driven by one radio frequency amplifier. The reconfigurable antenna group on each edge of the polygonal structure (the antenna architecture) may transmit a signal to the outside or receive a signal. Therefore, the gain of the antenna architecture is increased, and a scanning range of the antenna architecture is further expanded.

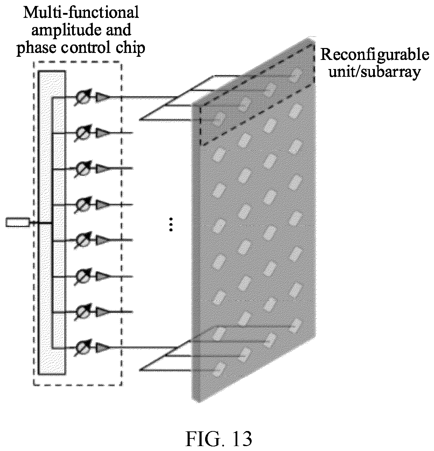

In a possible implementation, the antenna architecture includes a plurality of drive planes. Each drive plane includes a plurality of reconfigurable antenna groups in the drive structure, and there is a specific angle between different drive planes, so that the scanning range of the antenna architecture is expanded. Correspondingly, each reconfigurable antenna group in the drive plane is driven by one radio frequency amplifier. FIG. 13 is a diagram of a structure of a drive plane according to this application. As shown in FIG. 13, the drive plane has a scale of eight rows and four columns. A radio frequency amplifier drives an antenna unit in a one-drive-one manner in the vertical direction, and the radio frequency amplifier drives antenna units in a one-drive-four manner in the horizontal direction. In this way, each radio frequency amplifier drives an antenna subarray (that is, a reconfigurable antenna group) of one row and four columns, and a total quantity of radio frequency channels of the drive plane is 8. Functions such as phase shift and amplification of a radio frequency channel may be integrated into a multi-functional amplitude and phase control chip. One multi-functional amplitude and phase control chip may provide a plurality of radio frequency channels.

In actual application, based on the drive plane shown in FIG. 13, the radio frequency amplifier may drive antenna units in a one-drive-multiple manner in the vertical direction, and also drive antenna units in a one-drive-multiple manner in the horizontal direction. This is not specifically limited herein.

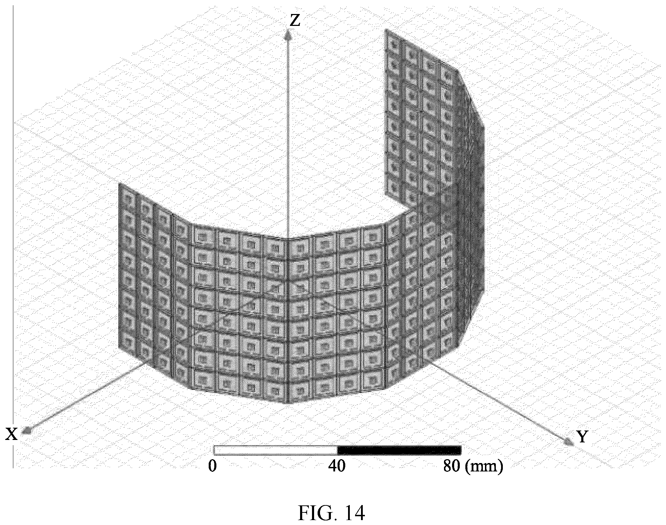

In a possible implementation, the antenna architecture includes a plurality of drive planes. The plurality of drive planes are connected, so that the scanning range of the antenna architecture is expanded. FIG. 14 is a diagram of a structure of a plurality of connected drive planes according to this application. As shown in FIG. 14, the antenna architecture includes seven connected drive planes. The seven connected drive planes form a hemiprism in an enclosed manner, and each drive plane includes eight rows and four columns of antenna units. It should be understood that quantities of planes, rows, columns, and antenna units in the antenna architecture shown in this application are all examples. In actual application, the quantities may have other different values. This is not specifically limited herein.

In a possible implementation, the antenna architecture includes a cylindrical structure. The cylindrical structure includes a plurality of drive planes. The plurality of drive planes are connected to form the cylindrical structure in an enclosed manner. The antenna architecture is a complete cylindrical structure, so that the scanning range of the antenna architecture is further expanded, and 360° full coverage of the scanning range is implemented. For example, the cylindrical structure included in the antenna architecture is a cylindrical array similar to the polyprism shown in FIG. 2.

Further, when the antenna architecture includes a plurality of drive planes, generally, not all the drive planes operate at a same moment. In this case, power consumption of the antenna architecture is excessively high. In addition, for a drive plane far away from the target direction, a gain of the drive plane transmitting a signal in the target direction is excessively low. Therefore, gains of all the drive planes operating at the same time are low. Therefore, the antenna architecture further includes a power-splitting gating network. The power-splitting gating network is for selecting a target drive plane from the plurality of drive planes in the antenna architecture. The target drive plane is at least one drive plane whose optional beam direction is closest to the target direction in the plurality of drive planes. In the antenna architecture, one or more drive planes closest to the target direction are selected by using the power-splitting gating network to operate, so that an antenna gain and a transmit power consumption benefit can be increased.

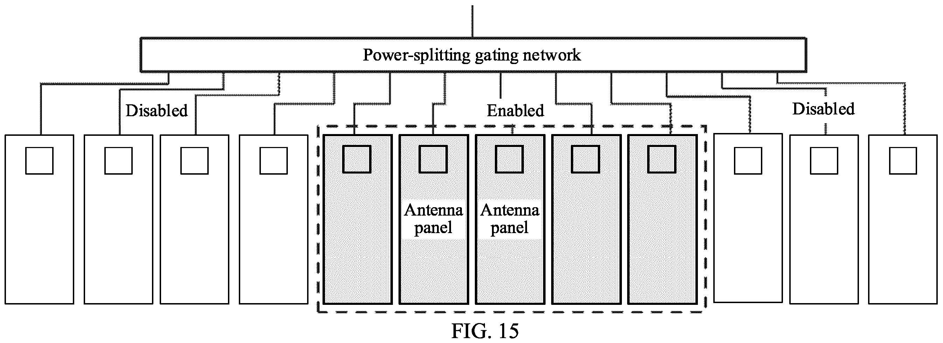

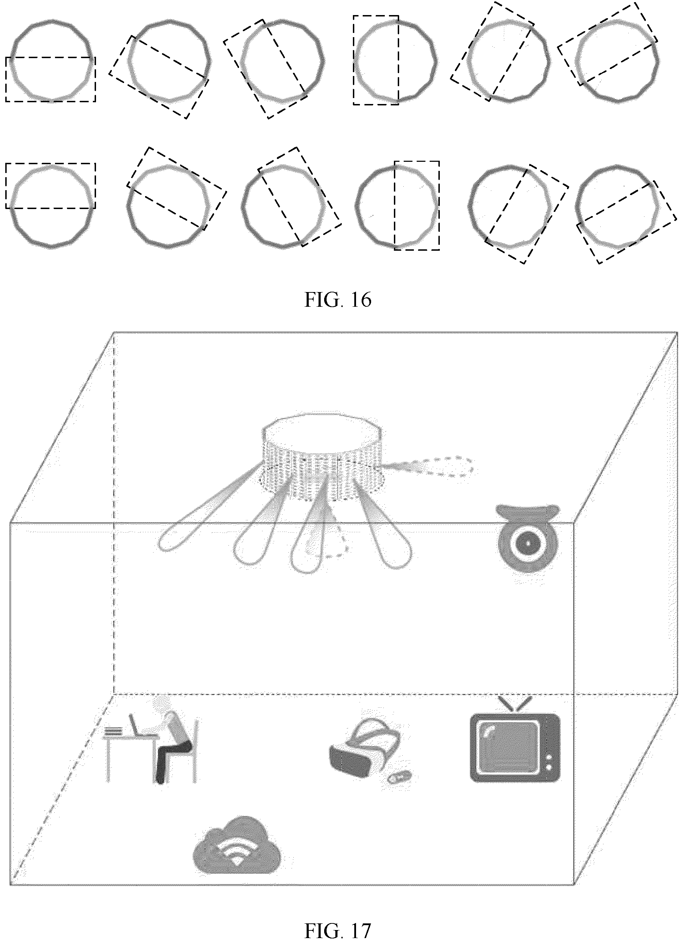

For ease of understanding, refer to FIG. 15. FIG. 15 is a diagram in which a plurality of drive planes in the antenna architecture cooperate with a power-splitting gating network in operating according to this application. As shown in FIG. 15, the antenna architecture includes 12 drive planes. The 12 drive planes are connected to the power-splitting gating network, and the power-splitting gating network controls enabling or disabling of each drive plane. However, in FIG. 15, five drive planes (shaded parts in FIG. 15) in these drive planes are enabled by the power-splitting gating network. It should be noted that, in actual application, a quantity of drive planes enabled by the power-splitting gating network are not limited, and a specific quantity may be dynamically adjusted based on an actual scenario. Correspondingly, for example, the antenna architecture includes 12 drive planes. FIG. 16 is a diagram of an operating state of a plurality of drive planes in the antenna architecture. FIG. 16 is a top view of the antenna architecture. The top view shows a regular dodecagon, and each edge represents a top view of one drive plane. An edge within a solid box represents a drive plane in an enabled state, and an edge outside a solid box represents a drive plane in a disabled state.

It can be learned from the foregoing descriptions that, in the antenna architecture, the plurality of drive planes of the cylindrical structure greatly expand the scanning range of the antenna architecture. However, the bottom of the cylindrical structure is not covered by a scanning range of the drive plane. Therefore, if an electronic device is located at the bottom of the cylindrical structure, the electronic device cannot receive a signal from the antenna architecture, or cannot transmit a signal to the antenna architecture. In view of this, at least one antenna unit may be disposed at the bottom of the cylindrical structure in the antenna architecture. The antenna unit may be configured to transmit a signal to the bottom of the cylindrical structure or receive a signal from the bottom of the cylindrical structure. Therefore, when the electronic device is located at the bottom of the cylindrical structure, the electronic device can still receive a signal from the antenna architecture, or transmit a signal to the antenna architecture, so that the scanning range of the antenna architecture is further expanded.

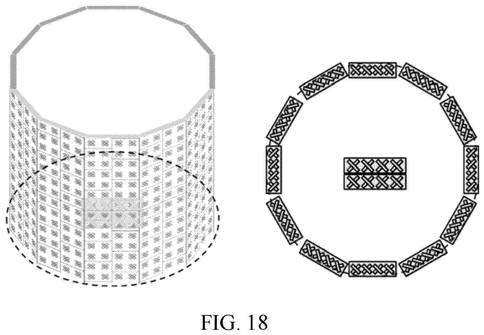

FIG. 17 is a diagram of a scenario in which the bottom of a cylindrical structure includes an antenna unit according to this application. As shown in FIG. 17, in an indoor scenario, an antenna architecture, which is a cylindrical structure, is located at the top in the indoor scenario. In this case, a plurality of drive planes of the cylindrical structure all transmit signals in the horizontal direction. Further, after an antenna unit is disposed at the bottom of the cylindrical structure, the antenna unit at the bottom may transmit a signal toward the bottom of the cylindrical structure, to expand a scanning range at the bottom of the antenna architecture. FIG. 18 is a diagram of a bottom structure of the antenna architecture according to this application. As shown in FIG. 18, eight antenna units are disposed at the bottom of the antenna architecture, to implement full coverage of the scanning range at the bottom of the antenna architecture.

To better implement the foregoing solutions in embodiments of this application, embodiments of this application further provide a method for increasing an antenna gain for implementing the foregoing solutions. Specifically, an embodiment of this application provides a method for increasing an antenna gain. The method is applied to an antenna architecture. The antenna architecture includes at least one drive structure. The drive structure includes a radio frequency amplifier and a reconfigurable antenna group. The reconfigurable antenna group includes a plurality of antenna units in a horizontal direction. The plurality of antenna units are arranged in a straight line. The horizontal direction is a direction parallel to the antenna architecture. The reconfigurable antenna group includes a plurality of optional beam directions. The radio frequency amplifier is configured to drive the plurality of antenna units in the reconfigurable antenna group. The method includes:
determining a target beam direction in the plurality of optional beam directions, where the target beam direction is an optional beam direction closest to a target direction in the plurality of optional beam directions; and
transmitting or receiving a signal in the target beam direction.

In a possible implementation, the antenna architecture includes a polygonal structure, the polygonal structure includes a plurality of drive structures, and each edge of the polygonal structure includes at least one reconfigurable antenna group in the drive structure. The method further includes:
determining a target drive edge, where the target drive edge is at least one edge closest to the target direction in the polygonal structure; and
the determining a target beam direction in the plurality of optional beam directions includes:
   determining the target beam direction in the plurality of optional beam directions of the target drive edge.

In a possible implementation, the antenna architecture includes a cylindrical structure, the cylindrical structure includes a plurality of drive planes, and each drive plane includes a plurality of reconfigurable antenna groups in the drive structure. The method further includes:
determining a target drive plane, where the target drive plane is at least one drive plane whose optional beam direction is closest to the target direction in the plurality of drive planes; and
the determining a target beam direction in the plurality of optional beam directions includes:
   determining the target beam direction in the plurality of optional beam directions of the target drive plane.

## Claims

1. An antenna architecture, comprising at least one drive structure, wherein the drive structure comprises a radio frequency amplifier and a reconfigurable antenna group, the reconfigurable antenna group comprises a plurality of antenna units in a horizontal direction, the horizontal direction is a direction parallel to the antenna architecture, and the plurality of antenna units are arranged in a straight line;
the reconfigurable antenna group comprises a plurality of optional beam directions;
the radio frequency amplifier is configured to drive the plurality of antenna units in the reconfigurable antenna group; and
the reconfigurable antenna group is configured to transmit or receive a signal in a target beam direction, wherein the target beam direction is an optional beam direction closest to a target direction in the plurality of optional beam directions.

2. The antenna architecture according to claim 1, wherein the antenna architecture comprises a polygonal structure, the polygonal structure comprises a plurality of drive structures, and each edge of the polygonal structure comprises at least one reconfigurable antenna group in the drive structure.

3. The antenna architecture according to claim 1, wherein the antenna architecture comprises a plurality of drive planes, each drive plane comprises a plurality of reconfigurable antenna groups in the drive structure, and there is an angle between the plurality of drive planes.

4. The antenna architecture according to claim 3, wherein the plurality of drive planes are connected.

5. The antenna architecture according to claim 3 or 4, wherein the antenna architecture comprises a cylindrical structure, and the cylindrical structure comprises the plurality of drive planes.

6. The antenna architecture according to claim 4 or 5, wherein the antenna architecture further comprises a power-splitting gating network, the power-splitting gating network is for selecting a target drive plane from the plurality of drive planes, and the target drive plane is at least one drive plane whose optional beam direction is closest to the target direction in the plurality of drive planes.

7. The antenna architecture according to claim 5, wherein the bottom of the cylindrical structure comprises at least one antenna unit, and the at least one antenna unit is configured to transmit a signal to the bottom of the cylindrical structure.

8. A method for increasing an antenna gain, wherein the method is applied to an antenna architecture, the antenna architecture comprises at least one drive structure, the drive structure comprises a radio frequency amplifier and a reconfigurable antenna group, the reconfigurable antenna group comprises a plurality of antenna units in a horizontal direction, the plurality of antenna units are arranged in a straight line, and the horizontal direction is a direction parallel to the antenna architecture; the reconfigurable antenna group comprises a plurality of optional beam directions; the radio frequency amplifier is configured to drive the plurality of antenna units in the reconfigurable antenna group; and the method comprises:
determining a target beam direction in the plurality of optional beam directions, wherein the target beam direction is an optional beam direction closest to a target direction in the plurality of optional beam directions; and
transmitting or receiving a signal in the target beam direction.

9. The method according to claim 8, wherein the antenna architecture comprises a polygonal structure, the polygonal structure comprises a plurality of drive structures, and each edge of the polygonal structure comprises at least one reconfigurable antenna group in the drive structure; and the method further comprises:
determining a target drive edge, wherein the target drive edge is at least one edge closest to the target direction in the polygonal structure; and
the determining a target beam direction in the plurality of optional beam directions comprises:
determining the target beam direction in the plurality of optional beam directions of the target drive edge.

10. The method according to claim 8, wherein the antenna architecture comprises a cylindrical structure, the cylindrical structure comprises a plurality of drive planes, and each drive plane comprises a plurality of reconfigurable antenna groups in the drive structure; and the method further comprises:
determining a target drive plane, wherein the target drive plane is at least one drive plane whose optional beam direction is closest to the target direction in the plurality of drive planes; and
the determining a target beam direction in the plurality of optional beam directions comprises:
determining the target beam direction in the plurality of optional beam directions of the target drive plane.
